# EUROPEAN PATENT APPLICATION

(11) **EP 4 560 342 A1**
(43) Date of publication of application: **28.05.2025**
(21) Application number: 24150624.5
(22) Date of filing: 08.01.2024
(51) Int. Cl.: G01R 33/3815

(54) **SYSTEM AND METHOD FOR DETECTING SUPERCONDUCTIVE STATE TRANSITION**

(30) Priority: 21.11.2023 US 202363601267 P
(71) Applicant: Koninklijke Philips N.V., 5656 AG Eindhoven (NL)
(72) Inventor: FALATEK, Austin, Eindhoven (NL); VAN LANEN, Ezra Petrus Antonius, Eindhoven (NL)
(74) Representative: Philips Intellectual Property & Standards

(57) **Abstract**

A system and method for detecting the superconducting status of a superconducting magnet used in magnet resonance imaging (MRI) are disclosed. The system comprises a sensor (208) having a magnet (230) positionable in a proximity of one or more superconducting coil elements (204) of the superconducting magnet. The sensor is configured to shift between a first state and a second state based on a repulsive force generated between the magnet and the one or more superconducting coil elements, wherein the second state is indicative that the one or more superconducting coil elements have reached superconducting status and wherein the first state is indicative that the one or more superconducting coil elements have not reached the superconducting status. The output of the sensor may control the operation of a persistent current switch (206) and connecting or disconnecting of a power supply (210) associated to the superconducting magnet.

## Description

### BACKGROUND

Magnetic resonance imaging (MRI) systems include a superconducting magnet to align and realign hydrogen nuclei (protons) in water molecules in a subject being imaged. A strong first magnetic field is applied to align the proton "spins" of the hydrogen nuclei, which can then be realigned systematically by applying a second magnetic field. MRI systems can include radio frequency (RF) coils to then selectively apply a B1 magnetic field in a transmit stage. In a receive stage, the hydrogen nuclei return to an original position (i.e., the position before the selective application of the B 1 magnetic field) and emanate a weak radio frequency signal which can be picked up and used to produce images. MRI systems also typically include a persistent current switch (PCS). A PCS is provided in a circuit arrangement in parallel with the superconducting magnet, allowing maintenance of a stable magnetic field for a long time.

Superconductivity is generally characterized as a state in which a material has zero electrical resistance at temperatures below a critical temperature threshold and in which impacts occur such as ejection of a magnetic field of/from the material. The superconducting magnet is energized by direct current power (DC power) from a power supply as the PCS presents resistance. For example, a typical power supply may provide 500 amperes of direct current. Afterwards, the PCS is switched to short-circuit (i.e., presents low electrical impedance) to the direct current (DC) power source by returning to the superconducting state, which allows the maintenance of the stable magnetic field.

In conventional MRI systems, superconducting windings (coils) of the superconducting magnet were typically constructed as superconducting fibers embedded in a copper matrix and immersed in liquid helium to maintain the superconducting windings (coils) of the superconducting magnet below the critical temperature. In this previous generation, the PCS was heated above the critical temperature of the superconductor material used in the PCS to make the PCS present resistance as the superconducting windings (coils) of the superconducting magnet are energized by the direct current power. Typically, the PCS has a critical temperature in the range of 6 to 9 Kelvin. In the conventional MRI systems, the PCS was also immersed in liquid helium which allowed reversion to the superconducting state quickly when the heater was turned off.

A newer type of "sealed" MRI system has been developed in which the PCS is not immersed in liquid helium. In such an MRI system, the sealed cooling system is charged with gas helium at an elevated temperature. The PCS is cooled by an external refrigeration system that takes significantly longer to cool the PCS before the MRI can be performed. Additionally, the amount of time required to cool the PCS may vary based on manufacturing variability in the superconducting magnet and the external cooling system. It is possible to determine which of the superconducting state and the resistive state the PCS is in by measuring the temperature, however sensors to measure cryogenic (very low) temperatures accurately are expensive, and subject to inaccuracies due to gradient temperatures across the PCS, for example.

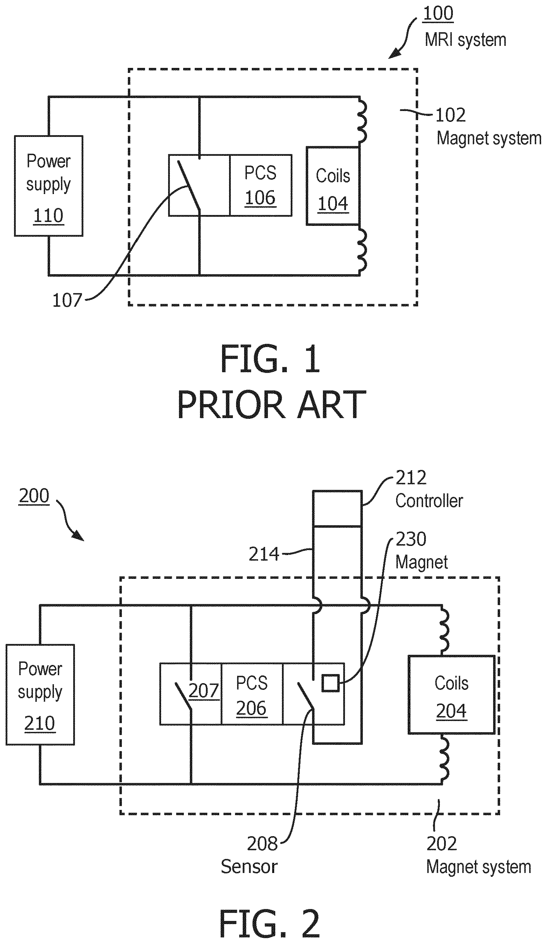

FIG. 1 illustrates an MRI system 100 having a known circuit arrangement of a known MRI system. In FIG. 1, the MRI system 100 has a magnet system 102 that includes the coils 104 of the superconducting magnet and the PCS 106, which includes a switch 107 (main PCS switch). The coils 104 of the superconducting magnet in the circuit of the MRI system 100 may be representative of the coils in the known MRI system described above. The power supply 110 provides a current in a circuit to the PCS 106. When the power supply provides current to the PCS 106, the PCS is considered to be in an open state. When the coils are in the superconducting state, the PCS 106 is in a closed state, and the magnet system is in the persistent state. Significant voltage is present when the PCS 106 presents resistance, but no significant voltage is present when the PCS 106 is in the superconducting state.

The previous generation of superconducting magnet systems in the known MRI system of FIG. 1 does not measure or directly determine the state of superconductivity of the superconducting magnet system. In those systems, the one or more superconducting coil elements 104 of the superconducting magnet and the PCS 106 are immersed in a helium bath, and the PCS 106 could have an open resistance on the order of 10 to 100 Ohms. When ramping (or energizing) the superconducting magnets in the previous generation, a voltage on the order of 6 volts was applied and the current in the superconducting magnets increased by the relationship V=L*di/dt, where V is voltage, L is inductance, and di/dt is the change in inductance over the change in time. While energizing the superconducting magnets, some direct current flowed through the PCS 106. When the PCS 106 reached the desired current the voltage across the PCS 106 started to drop as the current redistributes to the one or more superconducting coil elements 104 of the superconducting magnet with zero resistance in the superconducting state.

A newer type of MRI system has been developed in which the PCS is not immersed in liquid helium, and cooling of a PCS by external refrigeration system takes significantly longer to cool the PCS before the MRI can be performed. Additionally, the amount of time required to cool the PCS may vary based on manufacturing variability in the superconducting magnet and the external cooling system. Once it is assumed that the conductor has returned to superconducting, the magnet system will attempt to load the PCS with current. If at this point the PCS has not returned to the superconducting state, the switch will fail to close, and the magnet will not enter persistence. If the switch cannot be closed, the magnet will fail to complete energization, and return to the off-field state. Failure to ramp will result in a delay before the next attempted ramp, which is especially problematic at an install site when attempting to hand a magnet system over to a customer. Accordingly, new ways for determining the superconducting status of superconducting magnet system with a reasonable level of precision are required.

### SUMMARY

According to one aspect of the present disclosure, a system for detecting the superconducting status of a superconducting magnet used in magnetic resonance imaging (MRI) system includes: a superconducting magnet formed from one or more superconducting coil elements; a persistent current switch coupled to the superconducting magnet; a sensor including a magnet, wherein the sensor is coupled to the persistent current switch and an associated power supply, wherein in a first state the sensor electrically couples the associated power supply to the superconducting magnet; and in a second state the sensor electrically disconnects the associated power supply from the superconducting magnet, wherein the sensor switches between the first state and the second state based on a repulsive electromagnetic force generated between the magnet and superconducting status of superconducting coil elements, e.g., the sensor may be used to detect transition of the superconducting coil elements from the first state to the second state (e.g., from the resistive state to the superconducting state); and from the second state to the first state (e.g., from the superconducting state to the resistive state).

According to yet another aspect of the present disclosure, a method for detecting the superconducting status of a superconducting magnet used in magnetic resonance imaging (MRI) system, includes: providing a persistent current switch; providing a superconducting magnet formed from one or more superconducting coil elements; coupling a sensor to the persistent current switch and an associated power supply, switching the sensor between a first state in which the sensor electrically couples the associated power supply to the superconducting magnet; and a second state in which the sensor electrically disconnects the associated power supply from the superconducting magnet, wherein the sensor switches between the first state and the second state based on a superconducting status of superconducting coil elements.

The system and method utilize a repulsive electromagnetic force generated between the sensor and the one or more superconducting coil elements that actively switches sensor between the first state and the second state. The repulsive electromagnetic force is generated by a Meissner-effect interaction between sensor and the one or more superconducting coil elements.

### BRIEF DESCRIPTION OF THE DRAWINGS

The example embodiments are best understood from the following detailed description when read with the accompanying drawing figures. It is emphasized that the various features are not necessarily drawn to scale. In fact, the dimensions may be arbitrarily increased or decreased for clarity of discussion. Wherever applicable and practical, like reference numerals refer to like elements.
FIG. 1 illustrates a conventional superconducting configuration for a conventional MRI system.
FIG. 2 illustrates a circuit arrangement of an MRI system with superconducting status detection of the superconducting magnet system, in accordance with a representative embodiment.
FIGs. 3A-3B illustrate an exemplary sensor for an MRI system that is suitable for detecting the superconducting status of the superconducting magnet system, in accordance with a representative embodiment.
FIGs. 4A-4B illustrate another exemplary sensor for an MRI system that is suitable for detecting the superconducting status of the superconducting magnet system, in accordance with a representative embodiment.
FIG. 5 illustrate yet another exemplary sensor for an MRI system that is suitable for detecting the superconducting status of the superconducting magnet system, in accordance with a representative embodiment.
FIG. 6 illustrates an exemplary method for detecting a superconducting status of a superconducting magnet, in accordance with a representative embodiment.

### DETAILED DESCRIPTION

The following detailed description is for purposes of explanation and not limitation. Representative embodiments disclose specific details to provide a thorough understanding of an embodiment according to the present teachings. Descriptions of known systems, devices, materials, methods of operation and methods of manufacture may be omitted to avoid obscuring the description of the representative embodiments. Nonetheless, systems, devices, materials and methods that are within the purview of one of ordinary skill in the art are within the scope of the present teachings and may be used in accordance with the representative embodiments. It is to be understood that the terminology used herein is for purposes of describing particular embodiments only and is not intended to be limiting. The defined terms are in addition to the technical and scientific meanings of the defined terms as commonly understood and accepted in the technical field of the present teachings.

It will be understood that, although the terms first, second, third etc. may be used herein to describe various elements or components, these elements or components should not be limited by these terms. These terms are only used to distinguish one element or component from another element or component. Thus, a first element or component discussed below could be termed a second element or component without departing from the teachings of the inventive concept.

As used in the specification and appended claims, the singular forms of terms 'a', 'an' and 'the' are intended to include both singular and plural forms, unless the context clearly dictates otherwise. Additionally, the terms "comprises", "comprising", "includes", and/or "including," and/or similar terms when used in this specification, specify the presence of stated features, elements, and/or components, but do not preclude the presence or addition of one or more other features, elements, components, and/or groups thereof. As used herein, the term "and/or" includes any and all combinations of one or more of the associated listed items.

Unless otherwise noted, when an element or component is said to be "connected to", "coupled to", or "adjacent to" another element or component, it will be understood that the element or component can be directly connected or coupled to the other element or component, or intervening elements or components may be present. That is, these and similar terms encompass cases where one or more intermediate elements or components may be employed to connect two elements or components. However, when an element or component is said to be "directly connected" to another element or component, this encompasses only cases where the two elements or components are connected to each other without any intermediate or intervening elements or components.

As described herein, aspects of this invention relate to a system and method of sensing the transition of a superconductor magnet system from a resistive (normal) state to the beginning of super-conduction and vice versa. More broadly, aspects of this invention relate to a system and method of determining the superconducting status of a superconducting magnet and/or one or more superconducting coil elements at any point in time in substantially real time. This invention is described for use in sealed MRI magnets where the crossing of transition temperature and beginning of super-conduction is more critical to magnet performance than for conventional MR magnets. However, one skilled in the art will readily appreciate that this invention is applicable to any superconducting system wherein it is needed to determine the superconducting state of the system. Superconducting switch state detection for superconducting magnet control provides an ability to accurately determine the specific time a PCS is or will be closed and/or a superconducting magnet transitions from a non-superconducting state to a superconducting state or from a superconducting state to a non-superconducting state, as well as to eliminate the need for incorporation of other detection mechanisms in the MRI system, which may require potentially expensive components (e.g., expensive temperature sensor such as a Ruthenium Oxide sensor). The superconducting switch state detection described herein provides for certainty based on the actual superconducting state of the superconducting magnet system rather than being based on predictions, which may be based on averages of similar superconducting magnets without regard for construction variables or performance reduction due to wear or operating conditions.

FIG. 2 illustrates a system 200 for detecting a superconducting status of a superconducting magnet system 202 in accordance with aspects of the present invention. In FIG. 2, PCS 206 including a PCS switch 207 is connected to one or more superconducting coil elements 204 of a superconducting magnet, in accordance with a representative embodiment. The system 200 includes a superconducting magnet formed from one or more superconducting coil elements 204. The superconducting magnet further includes a PCS 206 coupled in a parallel arrangement to the superconducting coil elements 204. In one embodiment a sensor 208 including a magnet 230 is coupled to the PCS. In one embodiment, the sensor 208 including the magnet 230 is coupled in a parallel arrangement between the PCS 206 and an associated power supply 210. In a first state (non-superconducting state), the sensor 208 electrically couples the associated power supply 210 to the superconducting coil elements 204; and in a second state (superconducting state) the sensor 208 electrically disconnects the associated power supply 210 from the superconducting coil elements 204, such that the one or more superconducting coil elements 204 are in persistent mode with the PCS 206.

The sensor 208 switches between the first state and the second state based on a superconducting status of the superconducting coil elements 204. Aspects of the present invention make use of a Meissner-effect interaction between the magnet 230 of the sensor 208 and the one or more superconducting coil elements 204. In general, a repulsive electromagnetic force is generated between the sensor 208, which incorporates a magnet (e.g., a permanent magnet, an electromagnet) and the one or more superconducting coil elements 204 when the super superconducting coil elements 204 are in a superconducting state. The repulsive electromagnetic force is non-existent or negligible when the superconducting coil elements 204 are in a non-superconducting state. Thus, the sensor 208 provides an accurate indication of the superconducting status of the superconducting magnet 204 and/or the one or more superconducting coil elements 204 at any given time. The repulsive electromagnetic force applied between the sensor 208 and the superconducting magnet and/or one or more superconducting coil elements 204 is greater in the second state (superconducting state) than in the first state (non-superconducting state), which causes additional force sensed by the sensor and/or displacement of the position of the magnet in the sensor 208.

As shown in FIG. 2, the system may include a controller 212 operatively coupled to the sensor 208. The controller 212 may be mounted in an enclosure attached to the outside of the cryostat vessel of the superconducting magnet. As described more fully below, the controller 212 is configured to receive an output signal 214 generated from the sensor 208. The output signal 214 is indicative of the superconducting state of the superconducting magnet and/or one more of the superconducting coil elements 204. The controller 212 may be located based on the characteristics of the controller 212. For example, when a controller 212 includes an analog circuit that directly measures a characteristic across the PCS or receives an output from the sensor 208, the controller 212 may include one or more components directly in contact with the PCS 206 and/or sensor 208 and one or more other components located in an enclosure attached to the outside of the cryostat vessel. In embodiments described herein, electronics of the controller 212 may not actually be inside the cryostat vessel, and in some embodiments the controller 212 may be located separate from the superconducting magnet system 202.

The output signal 214 generated from the sensor 208 may be any type of signal that provides information regarding the superconducting state of the one or more superconducting coil elements 204 to the controller 212. The controller 212 is communicatively coupled to the MRI system in such a manner that the MRI system may make use of the information provided by the output signal 214 to the controller 212, such that the MRI system may ramp the superconducting magnet up or down based on the desired operation and/or perform MRI on a subject when the superconducting magnet is in a superconducting state.

The PCS 206 and the sensor 208 are illustrated as being connected in parallel between the power supply 210 and the superconducting magnet and/or one more of the superconducting coil elements 204. A person of ordinary skill in the art will appreciate that other embodiments or one more intervening components may be included in this configuration and other configurations and all such embodiments are deemed to within the scope of this disclosure.

The power supply 210 energizes the superconducting magnet system 202 primarily with a direct current until the one or more superconducting coil elements 204 are in a superconducting state. After the superconducting magnet system 202 is energized and in a superconducting state, the heater is disconnected from the PCS and as a result cools to superconducting temperature, and switches to persistent mode. At that time, the sensor 208 changes from a first state to a second state based on the one or more superconducting coil elements becoming superconductive. In the second state (superconducting state), the sensor 208 outputs an output signal 214, which may be used as an input to the controller 212 (or another component) to determine when actions to the system 200 are to be made. For example, the output signal 214 may be used by the controller to electrically disconnect the associated power supply 210 from the superconducting magnet system 202 and/or superconducting coil elements 204. Likewise, the output signal 214 may also be used by the controller 212 to electrically connect the associated power supply 210 to the superconducting magnet system 202 and/or superconducting coil elements 204 when in a resistive state. When the superconducting magnet system 202 is in the superconducting state, it can be used for MRI of a subject.

In FIG. 2 and most embodiments based on FIG. 2, the MRI system 200 that includes the magnet system 202 may employ so-called "cryofree" superconducting magnets as the superconducting magnet that includes the one or more superconducting coil elements 204. Such "cryofree" superconducting magnet systems may be referred to herein as sealed superconducting magnet systems with a sealed superconducting magnet. The term "sealed" means that the superconducting magnet system is not bathed in cryogen. Such sealed superconducting magnet systems with sealed superconducting magnets typically have a smaller volume of cryogenic material (e.g., less than 10 liters of liquid helium) when compared with previous non-sealed systems, which employed relatively large volumes of cryogenic material (e.g., 1000 liters of liquid helium). As stated above, the PCS 206 used in sealed systems take much longer to close (become persistent), e.g., on the order of an hour.

As shown in FIG. 2, the PCS 206 is connected across one or more superconducting coil elements 204 of the superconducting magnet system 202. The power supply 210 provides a current in a parallel circuit to the PCS 206. When the power supply provides current to the PCS 206, the PCS is in an open state (and the PCS 206 is said to be in the resistive state, which is also referred to as the first state in this description). When the one or more superconducting coil elements 204 and/or the magnet system 202 are in the superconducting state, the PCS switch 206 is in a closed state, and the superconducting magnet system 202 is in the persistent state, which is referred to as the second state in this description.

The sensor 208 is coupled to the PCS 206 and the associated power supply 210, wherein in a first state the sensor 208 electrically couples the associated power supply 210 to the superconducting magnet and/or the one or more superconducting coil elements 204. In a second state, the sensor 208 electrically disconnects the associated power supply 210 from the superconducting magnet and/or the one or more superconducting coil elements 204. The sensor 208 switches between the first state and the second state based on a superconducting status of superconducting coil elements 204. The sensor 208 may also be configured to switch from the second state to the first state based on the superconducting status of superconducting coil elements 204.

As discussed more fully with respect to the below embodiments, the sensor 208 includes one or more magnets in contact with or in close proximity to the one or more superconducting coil elements 204. When in a non-superconducting state, there is no or only a negligible amount of repulsive electromagnetic force generated between the permanent magnet of the sensor 208 and the one or more superconducting coil elements 204. However, this changes when the one or more superconducting coil elements 204 becomes superconducting. When the one or more superconducting coil elements 204 becomes superconducting, a repulsive electromagnetic force generated between the magnet of the sensor and the one or more superconducting elements, which causes the sensor to switch from a first state to a second state. This repulsive electromagnetic force is generated by a Meissner-effect interaction between permanent magnet of the sensor 208 and the one or more superconducting elements 206.

The sensor 208 is also configured to function when the one or more superconducting coil elements 204 changes from the superconducting state to the non-superconducting position. When the one or more superconducting coil elements 204 changes from the superconducting state to the non-superconducting position, the repulsive electromagnetic force between the permanent magnet of the sensor 208 and the one or more coil elements 204 dissipates and the sensor 208 is configured to generate an output signal representative of the non-conductive state of the one or more coil elements 204 to the controller 212. As such, the sensor 208 switches from the second state to the first state based when the superconducting coil elements 204 no longer being superconducting. One of the benefits of the sensor 208 and various embodiments described herein is that the superconducting status of a superconducting magnet and/or one or more superconducting coil elements may be detected at any point in substantially real time.

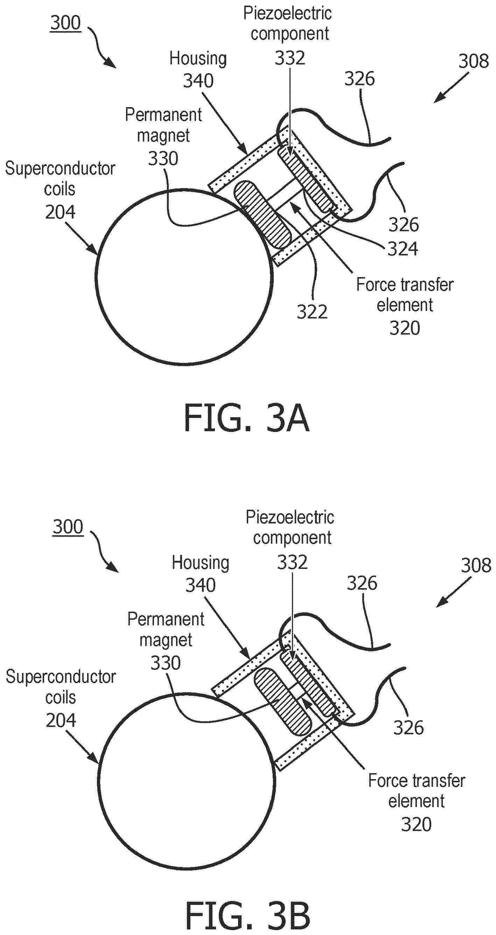

FIGs. 3A and 3B, illustrate an exemplary system 300 including sensor 308 in accordance with aspects of the present invention. The sensor 308 includes a force transfer element 320 having a first end 322 coupled to a magnet 330 and a second end 324 coupled to a piezoelectric component 332. As discussed more fully below, the force transfer element 320 may be rigid or elastic depending on design implementation. The piezoelectric component 322 is configured to output an output signal 214 through one or more measurement leads 326 to the controller 212 or another component of the MRI system 200. The output signal 214 may be representative of the electromagnetic force generated between the permanent magnet 330 and superconducting magnet system 202 and/or the one or more superconducting coil elements 204 and transferred through the force transfer element 320 to the piezoelectric component 332. In another embodiment, the output signal may be representative of the position of permanent magnet 330 in relation to the one or more superconducting coil elements 204 and/or the piezoelectric component 332. In either case, the output signal is coupled as an input to the controller 212 and used to determine the superconducting state of the one or more superconducting coil elements 204.

FIG. 3A illustrates an embodiment of the invention when the superconducting magnet system 202 and/or the one or more superconducting coil elements 204 are in a resistive state (e.g., non-superconducting state). As illustrated, the magnet 330 is near or in contact with the superconducting magnet or the one or more superconducting coil elements 204. In this state, there are generally no repulsive forces generated between magnet 330 and the one or more superconducting coil elements 204. As such, the force applied through the force transfer element 320 to the piezoelectric component 332 is less than when the magnet system 202 and/or the one or more superconducting coil elements 204 are in a superconducting state.

FIG. 3B illustrates an embodiment of the invention when the superconducting magnet system 202 and/or the one or more superconducting coil elements 204 are in a superconducting state. When the magnet system 202 and/or the one or more superconducting coil elements 204 are in a superconducting state, a repulsive electromagnetic force is generated between the magnet 330 of the sensor 308 and the superconducting magnet system 202 and/or the one or more superconducting coil elements 204. The repulsive force is generated by a Meissner-effect interaction between the magnet 330 of the sensor 308 and the superconducting magnet system 202 and/or the one or more superconducting coil elements 204. In the illustrated embodiment, the magnet 330 is displaced from a position near or in contact with the magnet system 202 to another distance, which is more distant from the one or more superconducting coil elements 204. This distance may be directly proportional to the amount of repulsive force exerted between the magnet 330 of the sensor 308 and the one or more superconducting coil elements 204.

In another embodiment, the magnet 330 may remain in substantially the same position (e.g., the force transfer element 320 is rigid), but the repulsive force exerted between the magnet 330 of the sensor 308 and the superconducting magnet system 202 and/or the one or more superconducting coil elements 204 increases, as measured by the piezoelectric component 332, based on the superconducting state of the superconducting magnet system 202 and/or the one or more superconducting coil elements 204.

FIGs 3A-3B illustrate the force transfer member 320 as a plunger or spring arrangement. It is noted that illustrated sensor arrangement and one or more conducting coil elements is not shown to scale for the sake of easier demonstration. The intent is that the sensor and the various components of the sensor (e.g., force transfer member 320 such as for example a spring or a plunger, permanent magnet, and piezoelectric component, will be compact, requiring the shortest travel distance possible to achieve a measurable signal. In this arrangement, the magnet will act upon a solid force transfer member (e.g., plunger or spring) that will push against the center of a piezoelectric component 332 when the expulsion of field occurs. This element will then convert that applied force to some voltage greater in magnitude than the steady-state voltage across the element for output as an input to a controller or other electronics for generation of an output signal indicative of the superconducting state of the superconducting magnet and/or the one or more superconducting coil elements 204.

FIGs. 3A-3B illustrate an optional housing 340 for the sensor 308. A person of ordinary skill in the art will readily appreciate that the housing 340 may be any size or shape. In one embodiment, the housing 340 is configured to at least partially enclose the force transfer member 320, force transfer element, and/or piezoelectric component 332. The housing may also be configured to at least partially enclose the permanent magnet 330 and a portion of the one or more superconducting coil elements 204.

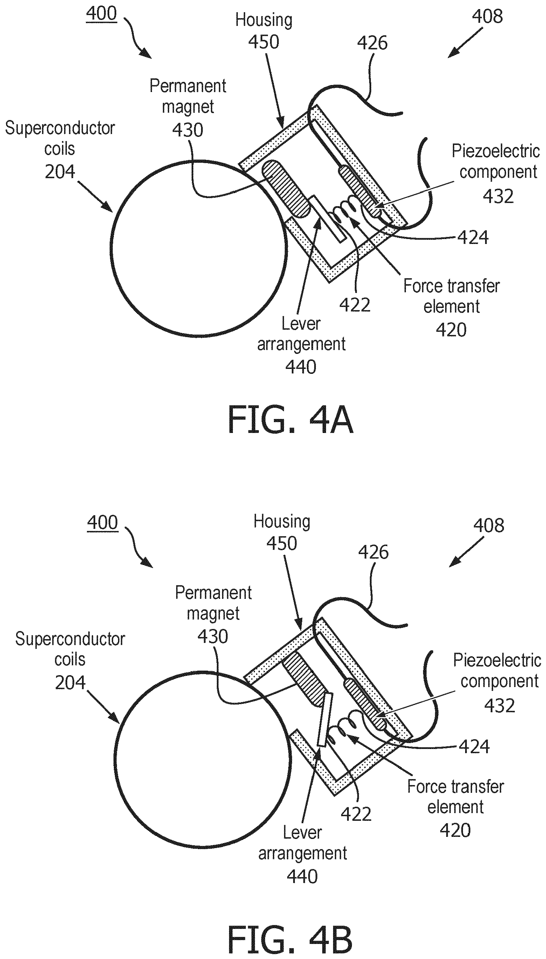

FIGs. 4A-4B illustrate another exemplary embodiment 400 in accordance with aspects of the present invention. The sensor 408 further includes a force transfer element 420 having a first end 422 coupled to a lever arrangement 440 and a second end 424 coupled to a piezoelectric component 432. The piezoelectric component 432 is configured to output an output signal representative of the electromagnetic force generated between a magnet 430 and the lever arrangement 440 through the force transfer element 420. In FIGs. 4A-4B, the force transfer element 420 is illustrated as a spring. In this embodiment (a spring spring-lever arrangement), the sensor functions similar to a spring scale, wherein repulsion of magnet 430 from the one or more superconducting coil elements 204 pushes the lever 440, which in turn pulls the force transfer element 432 (e.g., spring) downward, applying additional force to the piezoelectric component 432. The piezoelectric component 432 outputs an output signal commensurate with the applied force, which can be used as an input by the controller 212 to determine the superconducting status of the superconducting magnet system 202 and/or the one or more superconducting coil elements 204. As such, the sensor 408 is configured to switch from the first state (e.g., resistive) to the second state (e.g., superconducting) when the superconducting coil elements 204 are superconducting. The sensor 408 also switches from the second state to the first state based when the superconducting coil elements 204 is no longer in a superconducting state.

FIGs. 4A-4B illustrate an optional housing 450 for the sensor 408. A person of ordinary skill in the art will readily appreciate that the housing 450 may be any size or shape. In one embodiment, the housing 450 is configured to at least partially enclose the force transfer element 420, lever arrangement 440, and/or piezoelectric component 432. The housing 450 may also be configured to at least partially enclose the magnet 430 and at a portion of the one or more superconducting coil elements 204.

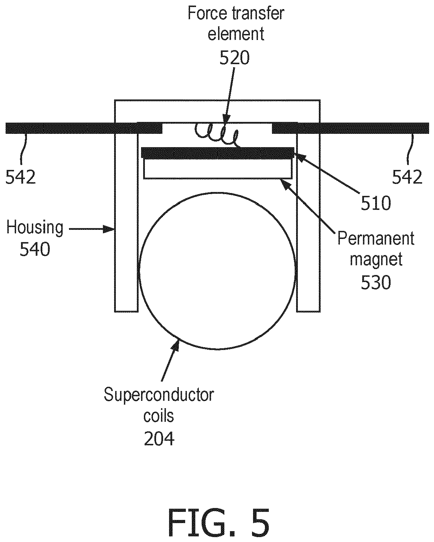

FIG 5 illustrates another exemplary embodiment in accordance with aspects of the present invention. The sensor embodiment illustrated in FIG 5 is an arrangement similar to a reed switch. In this embodiment, the force transfer element 520 (illustrated as a spring) holds the magnet 530 and the electrical contacts (510 and 542) separated when the superconducting magnet system 202 and/or the one or more superconducting coil elements 204 are in a normal state (e.g., resistive). The contacts (510 and 542) will be closed as soon as the Meissner effect causes the magnet 530 to be pushed upward (repulsed) from the one or more superconducting coil elements 204, such that the contacts (510 and 542) engage. In this embodiment, a low power external current supply may be used to detect the state of the switch, which would produce an output signal indicative of the superconducting status of the superconducting magnet system 202 and/or the one more superconducting coil elements 204, which is output to the controller 212. For example, the output signal may be binary, an analog or digital signal proportionate to the force and/or position of a component of the system. As such, the sensor is configured to switch from the first state (e.g., resistive) to the second state (e.g., superconducting) when the superconducting coil elements 204 are superconducting.

When the superconducting coil elements 204 become non-superconducting the repulsive force between the magnet 530 and the superconducting coil elements 204 subsides and the force transfer element 520 extends, which opens the circuit made between the contacts 510 and 542. An output signal indicative that the superconducting magnet system 202 and/or the one more superconducting coil elements 204 is in a non-superconducting state is generated and output as an input to the controller 212. As such, the sensor switches from the second state to the first state based on when the superconducting coil elements 204 no longer being superconducting.

In this embodiment, the sensor includes one or more first electric contacts 510 coupled to at least a portion of the permanent magnet 530. The force transfer element 520 includes a first end mechanically coupled to the to the permanent magnet 530 and a second end mechanically coupled to a housing 540. The housing 540 may include at least one or more second electrical contacts 542 that are configured to electrically couple with the one or more first electric contacts 510 when the one or more superconducting coil elements are in the superconducting status. That is, the repulsive force exerted between the magnet 530 of the sensor and the superconducting magnet system 202 and/or the one or more superconducting coil elements 204 forces the electrical contacts 510 into electrical contact with electrical contacts 542. When a circuit is formed from electrical contacts 542 engaging directly or indirectly (through another conductive component) with electrical contacts 510 an output signal is generated, which is indicative that the magnet system 202 and/or the one or more superconducting coil elements 204 are in a superconducting state. When the circuit formed from the coupling of electrical contacts 510 and 542 is or becomes an open circuit, an output signal is generated, which is indicative of that the magnet system 202 and/or the one or more superconducting coil elements 204 are in a non-superconducting state. The output signal may input to the controller 212 to determine superconducting status and/or used to control the system.

A person of ordinary skill in the art will readily appreciate that the housing 540 may be any size or shape. In one embodiment, the housing 540 is configured to at least partially enclose the force transfer member 520 and electrical contacts 510 and electrical contacts 542. Optionally, the housing is configured to at least partially encloser the permanent magnet 530 and at a portion of the one or more superconducting coil elements 204.

The various embodiments provided above identify various force transfer elements 320, 420, 520. A person of ordinary skill in the art will readily appreciate that the force transfer element may take a variety of forms including, for example, a spring, plunger, or any other type of material suitable to apply a mechanical force in a superconducting environment.

The various embodiments provided above identify a magnet 330, 430, 530. A magnet may be take any form, size and/or shape. In one embodiment, the magnet 330, 430, 530 may be a permanent magnet. A permanent magnet is generally defined as materials where the magnetic field is generated by the internal structure of the material itself. In another embodiment, the magnet 330, 430, 530 may be an electromagnet. An electromagnet is generally a metal core made into a magnet by the passage of electric current through a coil surrounding it. For example, during ramping of the magnet system to a superconducting state, the electromagnet may have a current applied. When the superconducting state is reached the current to the electromagnet may be turned off. In another embodiment, the current to the electromagnet may always be applied to the electromagnet, which would allow detection of the magnet system transitioning to the superconducting from the resistive state, as well as transitioning from the superconducting state to the resistive state.

A person of ordinary skill in the art will also readily appreciate that the piezoelectric component 332, 432 may take a variety of forms including, for example, a pressure sensor, a position sensor, a transducer, a hall effect transducer, strain gauge, or any other piezoelectric component that is suitable to output an output signal that may be used to indicate the superconducting status of the superconducting magnet system 202 and/or the one or more superconducting coil elements 204.

The controller 212 is shown in close proximity to the one or more superconducting coil elements 204 and the PCS 206 in FIG. 2. However, the controller 212 may be provided apart from the circuit arrangement, such as when connected by a communications wire that carries digital signals generated by an analog-to-digital converter that is proximate to the PCS 206. Additionally, a controller 212 may include a set of elements that work together, such as a memory that stores instructions and a processor such as a microprocessor that executes the instructions to implement processes described herein. A controller 212 may also be or include a processor such as an application-specific integrated circuit (ASIC) that automatically performs logical functions without necessarily requiring software, such as based on analog detections of voltage levels reaching a threshold so as to trigger a reaction.

The controller 212 may include a detection circuit. The detection circuit may include an ADC (analog-to-digital controller), a processor and a memory. The ADC detects analog voltage readings from a PCS such as the PCS 206 and/or any of the sensor embodiments according to the invention illustrated in the various figures and converts the detected analog voltage reading from an analog reading to a digital value. The ADC outputs the digital signal with the digital value to the processor. The analog voltage readings are based on variable voltages across the PCS and/or any of the sensor embodiments according to the invention based on whether the superconducting magnet system 202 and/or the one or more superconducting coil elements 204 are in the resistive state (non-superconducting) or the superconducting state. The processor retrieves or otherwise receives software instructions from the memory and executes the instructions to determine that the superconducting magnet system 202 and/or one or more superconducting coil elements 204 are in a non-superconducting or superconducting state.

For controller 212, a person of ordinary skill in the art will readily appreciate that logical operations are performed on digital data by processors executing instructions from one or more memories. However, logical operations may also be performed by an application-specific integrated circuit, which may include circuitry for generating an output signal representative of the superconducting state of the superconducting magnet system 202 and/or the one or more superconducting coil elements 204.

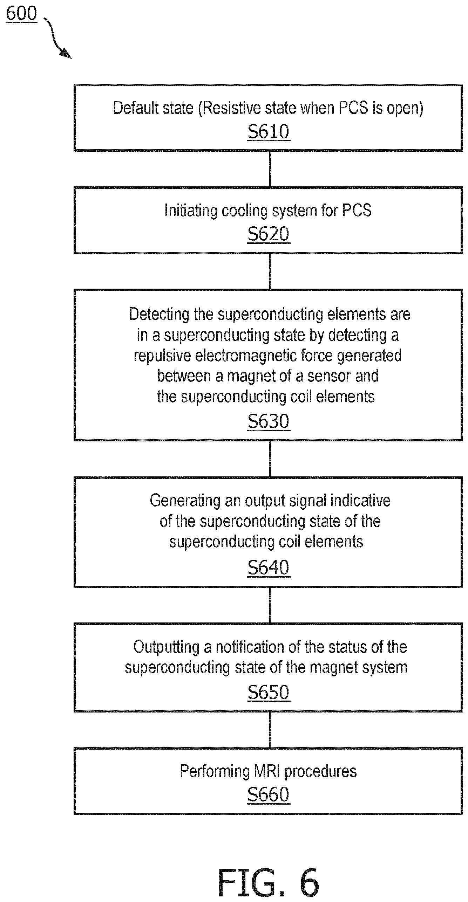

FIG. 6 illustrates a process or a method 600 of detecting a superconducting status of a superconducting magnet, in accordance with a representative embodiment. As illustrated in FIG. 2, the superconducting magnet includes: a PCS 206, a sensor of any of the embodiments according to the invention, and one or more superconducting coil elements 204. An associated power supply is provided, which may be coupled to one or more components of the superconducting magnet. The PCS 206, the sensor of any of the embodiments according to the invention, and the one or more superconducting coil elements 204 are coupled in a parallel arrangement, as illustrated in FIG. 2. The sensor of any of the embodiments according to the invention may be coupled between the PCS 206 and the associated power supply 210 in a parallel arrangement. The PCS 206 may be coupled between the sensor of any of the embodiments according to the invention and the one or more superconducting coil elements 204.

The process of FIG. 6 starts at S 610 in a default state, which in the embodiment of FIG. 6 is a resistive state (i.e. non-superconducting state) when the PCS 206 is open. The default state S610 may be the state when the PCS 206 is not cooled and is therefore above the critical temperature (e.g., the temperature needed for the magnet system 202 and/or the one or more superconducting coil elements 204 to be superconducting) and in an open circuit configuration.

At S620, the process of FIG. 6 includes initiating a cooling system for the PCS 206. The cooling system is not shown in the circuit arrangement 200 of FIG. 2 but may be controlled manually or automatically by a machine to perform S620.

At S630, the process of FIG. 6 includes switching the sensor between a first state in which the sensor electrically couples the associated power supply to the superconducting magnet; and a second state in which the sensor electrically disconnects the associated power supply from the superconducting magnet when the sensor of any of the embodiments according to the invention detects that the one or more superconducting coil elements 204 are in a superconducting state. As stated above, this state detection is accomplished when the sensor of any of the embodiments according to the invention detects a repulsive electromagnetic force generated between an interaction of a permanent magnet of the sensor and the one or more superconducting coil elements 204.

At S640, the process of FIG. 6 includes generating an output signal for output to a controller 212, which can be used by an MRI system to indicate whether the magnet system 202 is in a non-superconducting or a superconducting state. When the magnet system 202 is in a superconducting state, the MRI system may be used for imaging a patient. When the magnet system 202 is in a non-superconducting state, the controller may be used to control the refrigeration system (not shown) in order to get the PCS 206 and/or the one or more superconducting coils to a superconducting temperature.

At S650, the process of FIG. 6 includes outputting a notification of the status of the superconducting state of the magnet system 202. The notification may be by an audible signal, a visual signal such as a light illuminating, and/or by a data signal provided to a communications device or a computer monitor in order to alert an operator of the superconducting status of the magnet system 202.

At S660, the process of FIG. 6 concludes with performing MRI procedures. The MRI procedures are performable based on confirmation that the magnet system 202 is in the superconducting state.

The illustrations of the embodiments described herein are intended to provide a general understanding of the structure of the various embodiments. The illustrations are not intended to serve as a complete description of all of the elements and features of the disclosure described herein. Many other embodiments may be apparent to those of skill in the art upon reviewing the disclosure. Other embodiments may be utilized and derived from the disclosure, such that structural and logical substitutions and changes may be made without departing from the scope of the disclosure. Additionally, the illustrations are merely representational and may not be drawn to scale. Certain proportions within the illustrations may be exaggerated, while other proportions may be minimized. Accordingly, the disclosure and the figures are to be regarded as illustrative rather than restrictive.

One or more embodiments of the disclosure may be referred to herein, individually and/or collectively, by the term "invention" merely for convenience and without intending to voluntarily limit the scope of this application to any particular invention or inventive concept. Moreover, although specific embodiments have been illustrated and described herein, it should be appreciated that any subsequent arrangement designed to achieve the same or similar purpose may be substituted for the specific embodiments shown. This disclosure is intended to cover any and all subsequent adaptations or variations of various embodiments. Combinations of the above embodiments, and other embodiments not specifically described herein, will be apparent to those of skill in the art upon reviewing the description.

The Abstract of the Disclosure is provided to comply with 37 C.F.R. § 1.72(b) and is submitted with the understanding that it will not be used to interpret or limit the scope or meaning of the claims. In addition, in the foregoing Detailed Description, various features may be grouped together or described in a single embodiment for the purpose of streamlining the disclosure. This disclosure is not to be interpreted as reflecting an intention that the claimed embodiments require more features than are expressly recited in each claim. Rather, as the following claims reflect, inventive subject matter may be directed to less than all of the features of any of the disclosed embodiments. Thus, the following claims are incorporated into the Detailed Description, with each claim standing on its own as defining separately claimed subject matter.

The preceding description of the disclosed embodiments is provided to enable any person skilled in the art to practice the concepts described in the present disclosure. As such, the above disclosed subject matter is to be considered illustrative, and not restrictive, and the appended claims are intended to cover all such modifications, enhancements, and other embodiments which fall within the true spirit and scope of the present disclosure. Thus, to the maximum extent allowed by law, the scope of the present disclosure is to be determined by the broadest permissible interpretation of the following claims and their equivalents and shall not be restricted or limited by the foregoing detailed description.

## Claims

1. A system for detecting superconducting status of a superconducting magnet (202) used in a magnetic resonance imaging system, comprising:
a sensor (208) comprising a magnet (230) positionable in a proximity of one or more superconducting coil elements (204) of the superconducting magnet;
wherein the sensor is configured to shift between a first state and a second state based on a repulsive force generated between the magnet and the one or more superconducting coil elements, wherein the second state is indicative that the one or more superconducting coil elements have reached superconducting status and wherein the first state is indicative that the one or more superconducting coil elements have not reached the superconducting status.

2. The system of claim 1, wherein the sensor is configured to shift between the second state and the first state when a repulsive electromagnetic force generated between the magnet of the sensor and the one or more superconducting coil elements dissipates.

3. The system of claim 1 or 2, wherein the repulsive force is generated by a Meissner-effect interaction between the magnet of the sensor and the one or more superconducting coil elements.

4. The system of any of claims 1 to 3, wherein the sensor further includes a force transfer element (320) having a first end coupled to the magnet (330) and a second end coupled to a piezoelectric component (322), wherein the piezoelectric component is configured to output an output signal representative of the electromagnetic force generated between the magnet and the one or more superconducting coil elements and transferred by the force transfer element to the piezoelectric component.

5. The system of any of claims 1 to 3, wherein the sensor further includes a force transfer element (420) having a first end coupled to a lever arrangement (440) and a second end coupled to a piezoelectric component (432), wherein the piezoelectric component is configured to output an output signal representative of the electromagnetic force generated between the magnet (430) and the one or more superconducting coil elements and transferred by the lever arrangement through the force transfer element to the piezoelectric component.

6. The system of claim 4 or 5, further including a housing (340, 450), wherein the housing is configured to at least partially contain at least one of the magnet and the force transfer element.

7. The system of any of claims 1 to 3, wherein the sensor includes one or more first electric contacts (510) coupled to at least a portion of the magnet (530), a force transfer element (520) having a first end mechanically coupled to the magnet and a second end mechanically coupled to a housing (540), wherein the housing includes at least one or more second electric contacts (542) that are configured to electrically couple with the one or more first electric contacts when the superconducting coil elements are in the superconducting status.

8. The system of any of the claims 1 to 7, wherein the magnet is at least one selected from a permanent magnet and an electromagnet.

9. The system of any one of claims 1 to 8, further including a controller (212) configured to receive an output signal from the sensor, wherein the output signal is representative of the repulsive force generated between the magnet and the one or more superconducting coil elements.

10. The system of any of the claims 1 to 9, further comprising:
the superconducting magnet (202) including the one or more superconducting coil elements (204);
a persistent current switch (206) coupled to the superconducting magnet, wherein operating the persistent current switch is based on whether the sensor is in the first state or in the second state.

11. The system of claim 10, wherein the persistent switch and the superconducting magnet is connectable to an associated power supply (210), wherein connecting and/or disconnecting the associated power supply to the superconducting magnet is based on whether the sensor is in the first state or in the second state.

12. A method of detecting superconducting status of a superconducting magnet (202) used in a magnetic resonance imaging system, comprising:
positioning a sensor (208) comprising a magnet (230) in a proximity of one or more superconducting coil elements (204) of the superconducting magnet;
shifting between a first state and a second state of the sensor based on a repulsive force generated between the magnet and the one or more superconducting coil elements, wherein the second state is indicative that the one or more superconducting coil elements have reached superconducting status and wherein the first state is indicative that the one or more superconducting coil elements have not reached the superconducting status.

13. The method of claim 12, comprising:
shifting between the second state and the first state of the sensor when a repulsive electromagnetic force generated between the magnet of the sensor and the one or more superconducting coil elements dissipates.

14. The method of claim 12 or 13, further comprising:
operating a persistent current switch (206) coupled to the superconducting magnet based on whether the sensor is in the first state or in the second state.

15. The method of claim 14, comprising:
coupling and/or decoupling a power supply (210) to the superconducting magnet based on an output of the sensor related to the first state or the second state.
